# EUROPÄISCHE PATENTSCHRIFT

(11) **EP 3 157 785 B1**
(45) Veröffentlichungstag und Bekanntmachung des Hinweises auf die Patenterteilung: **06.11.2019**
(21) Anmeldenummer: 15747996.5
(22) Anmeldetag: 24.07.2015
(51) Int. Cl.: B60R 16/023, A62C 3/07, A62C 3/16, B61D 17/10, B61D 49/00, B61L 15/00

(54) **FAHRZEUG**
VEHICLE
VÉHICULE

(30) Priorität: 19.08.2014 DE 102014216425
(43) Veröffentlichungstag der Anmeldung: 26.04.2017
(73) Patentinhaber: Siemens Mobility GmbH, 81739 München (DE)
(72) Erfinder: MULL, Peter, 90471 Nürnberg (DE); TOKMAN, Iossif, 90449 Nürnberg (DE)
(86) Internationale Anmeldenummer: PCT/EP2015/066995
(87) Internationale Veröffentlichungsnummer: WO 2016/026651

(56) Entgegenhaltungen:
- EP-A1- 1 662 453
- EP-A1- 1 792 762
- EP-A2- 1 095 836
- EP-A2- 2 433 676
- WO-A1-2011/104278
- DE-A1- 10 349 573
- DE-A1-102005 057 542
- DE-B3-102012 204 300
- RU-U1- 61 655

## Beschreibung

Die Erfindung betrifft ein Fahrzeug, insbesondere zur Personen- und/oder Gutbeförderung, mit wenigstens einem brandgeschützten elektrischen Netz, mit wenigstens einem ersten Fahrzeugbereich, der eine erste Brandlast aufweist und zur Personen- und/oder Gutbeförderung ausgestaltet ist, und wenigstens einem zweiten Fahrzeugbereich, der eine zweite zur ersten Brandlast kleinere Brandlast aufweist und nicht zur Personen- und/oder Gutbeförderung ausgestaltet ist. Derartige Fahrzeuge sind beispielsweise Schienenfahrzeuge, bei denen der ersten Fahrzeugbereich beispielsweise ein Unterflurbereich und der zweite Fahrzeugbereich beispielsweise ein Fahrgastbereich ist. In solchen Fahrzeugen ist üblicherweise ein brandgeschütztes elektrisches Netz vorhanden, das Teil eines gesamten elektrischen Netzes ist und das im Fall eines Feuers vor dessen Auswirkungen besonders geschützt werden muss. Das brandgeschützte elektrische Netz umfasst beispielsweise eine Brandmeldeanlage, die mit Feuer- oder Rauchmeldern im Fahrzeug gekoppelt ist und ein Alarmsignal im Falle eines Brandes ausgibt, eine Notfahreinrichtung, durch die das Fahrzeug im Falle eines Brandes eine Zeitlang weiterfahren kann, oder ein Personeninformationssystem, das beispielsweise Sprachhinweise an die Fahrgäste ausgibt im Falle eines Feuers. Für die vom brandgeschützten elektrischen Netz ausgeführten Funktionen muss sichergestellt werden, dass diese auch bei einem Brand im Fahrzeug weiter zur Verfügung stehen. Der Brandschutz kann beispielsweise durch ein separates brandschützendes Gehäuse oder eine brandschützende Ummantelung stattfinden. Die Ausgestaltung des brandgeschützten elektrischen Netzes in dem Fahrzeug bedeutet einen erheblichen Kosten- und Montageaufwand.

EP 1662 453 A1 offenbart eine Kommunikationseinrichtung. RU 61 655 U1 offenbart einen Personenwaggon.

Daher ist es die Aufgabe der vorliegenden Erfindung, ein Fahrzeug der eingangs genannten Art bereitzustellen, bei dem das brandgeschützte elektrische Netz mit weniger Aufwand verbunden ist.

Die genannte Aufgabe wird von dem Fahrzeug nach Anspruch 1 gelöst.

Dies hat den Vorteil, dass in dem zweiten eine geringere Brandlast aufweisenden Bereich weniger Brandschutzmaßnahmen getroffen werden müssen, um das brandgeschützte elektrische Netz ordnungsgemäß herzustellen.

Unter der Brandlast eines bestimmten Bereichs des Fahrzeugs versteht man die Energie, die bei einem Brand in diesem Bereich frei wird und damit für Schutzmaßnahmen gegen einen solchen Brand zu berücksichtigen ist.

Wenn ein möglichst großer Anteil des brandgeschützten elektrischen Netzes in dem Bereich mit der geringeren Brandlast verläuft, müssen weniger Brandschutzmaßnahmen getroffen werden.

Die Erfindung kann durch verschiedene vorteilhafte Ausgestaltungen weiterentwickelt werden, die im Folgenden beschrieben sind.

Der zweite Fahrzeugbereich ist erfindungsgemäß nicht zur Personen- und/oder Gutbeförderung ausgestaltet. Dies hat den Vorteil, dass Bereiche, die nicht zur Personen- und/oder Gutbeförderung ausgestaltet sind, wie beispielsweise ein Unterflurbereich eines Zuges eine geringere Brandlast aufweist als beispielsweise ein Fahrgastbereich. Dies ist dadurch zu erklären, dass Fahrgäste im Fahrgastbereich viele Gegenstände mit sich führen, die eine hohe Brandlast aufweisen, wie beispielsweise Gepäckstücke, Zeitungen etc. Hierdurch wird eine hohe Brandlast des Fahrgastbereichs vermutet. Da in anderen Bereichen, wie beispielsweise einem Unterflurbereich weniger brennbare Gegenstände angeordnet sind, ist die Brandlast in diesen Bereichen geringer.

Der zweite Fahrzeugbereich kann unterhalb des ersten Fahrzeugbereichs angeordnet sein. So kann eine Verkabelung zwischen den Bereichen leicht durchgeführt werden, die beispielsweise nötig ist, um die Rauchmelder mit der Brandmeldeanlage zu verbinden.

In einer vorteilhaften Ausgestaltung kann das Fahrzeug einen Fahrzeugkasten aufweisen, der im zweiten Fahrzeugbereich wenigstens einen brandgeschützten Abschnitt ausbildet, und kann zumindest ein Teil des brandgeschützten Netzes in dem brandgeschützten Abschnitt angeordnet sein. Dies hat den Vorteil, dass der brandgeschützte Abschnitt des Fahrzeugkastens ausgenutzt wird für die Installation des brandgeschützten Netzes, das in diesem Abschnitt weniger Brandschutzmaßnahmen benötigt. Der Fahrzeugkasten ist die Grundkonstruktion des Fahrzeugs, der beispielsweise als Stahlschweißkonstruktion ausgebildet ist

Erfindungsgemäß umfasst das Fahrzeug ein brandschutzgebendes Gehäuse im zweiten Fahrzeugbereich, in dem wenigstens ein Teil des brandgeschützten Netzes angeordnet ist. Dies hat den Vorteil, dass in dem brandgeschützten Gehäuse Teile des brandgeschützten Netzes vormontiert werden können und so die Montage des Fahrzeugs vereinfacht wird.

Um die Montage weiter zu vereinfachen, kann das brandgeschützte Netz wenigstens einen Stecker umfassen, durch den das brandgeschützte Netz im Innern des Gehäuses mit einem vom Gehäuse externen Netz verbindbar ist. Ferner kann das brandgeschützte Netz mehrere Teilnetze mit unterschiedlichen im Brandfall erforderlichen Funktionalitäten umfassen, wobei alle Teilnetze in dem gemeinsamen Gehäuse angeordnet sind. Die Funktionalitäten können beispielsweise die einer Brandmeldeanlage, die für eine Notfahrt des Fahrzeugs und/oder die eines Personeninformationssystems des Fahrzeugs umfassen.

Um die Baugröße und die Verlustleistung des brandgeschützten Netzes zu verringern, kann das brandgeschützte Netz wenigstens eine gedruckte Platine umfassen. Besonders vorteilhaft ist es, wenn die gedruckte Platine in dem oben genannten Gehäuse angeordnet ist. Gedruckte Platinen sind besonders einfach zu montieren und nehmen besonders wenig Platz in Anspruch.

Ferner kann das brandgeschützte Netz wenigstens ein Schaltelement, insbesondere ein Relais, umfassen, das auf der Platine angeordnet ist. Dies hat den Vorteil, dass das Schaltelement auf der Platine bei Montage bereits fertig verkabelt ist und sich so der Montageaufwand verringert. Ferner ist die Verlustleistung von Relais, beispielsweise im Vergleich zu Schützen, gering. Durch eine geringe Verlustleistung verringert sich das Brandrisiko, insbesondere wenn die Schaltelemente in dem oben genannten Gehäuse angeordnet sind, wodurch weniger Brandschutzmaßnahmen nötig sind.

Die Erfindung wird im Folgenden mit Bezug auf die beispielhafte Ausführungsform in den beigefügten Zeichnungen erläutert.

Es zeigen:
- Figur 1: eine schematische Darstellung einer ersten Ausführungsform eines Fahrzeugs mit eingebauter erfindungsgemäßer Brandschutzeinrichtung;
- Figur 2: eine schematische Darstellung der Brandschutzeinrichtung aus Figur 1.;

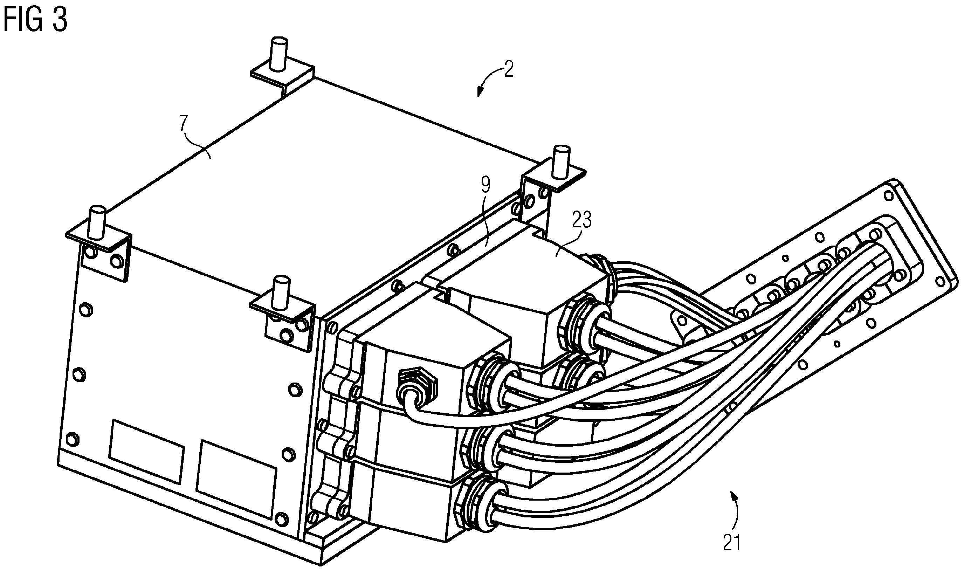

- Figur 3: eine schematische Darstellung der Brandschutzeinrichtung mit Darstellung der Anbindung an die fahrzeugseitige Verkabelung aus Figur 1.

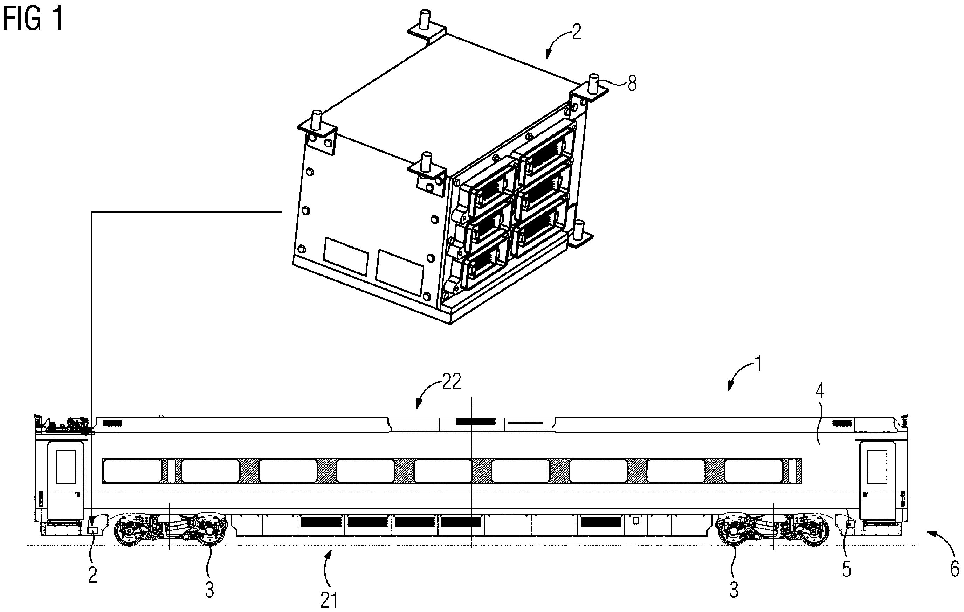

Figur 1 zeigt ein Fahrzeug 1, in dem eine beispielhafte Ausführungsform der erfindungsgemäßen Brandschutzeinrichtung 2 eingebaut ist. Das Fahrzeug ist hier als ein Schienenfahrzeug ausgebildet, das mit seinen Rädern 3 auf Schienen (nicht dargestellt) fährt. Das Fahrzeug 1 kann dabei Teil eines Zuges zur Personenbeförderung sein. Das Fahrzeug 1 weist zur Beförderung der Fahrgäste einen Fahrgastbereich 4 auf, der nach unten durch einen Boden 5 begrenzt ist. Unterhalb des Bodens 5 befindet sich ein Unterflurbereich 6, in dem unter anderem die Brandschutzeinrichtung 2 angeordnet ist.

Die Brandschutzeinrichtung 2 umfasst insbesondere ein Gehäuse 7, ein internes Netz 20, Befestigungsmittel 8, mehrere Steckverbinder 9 und mehrere Platinen 10.

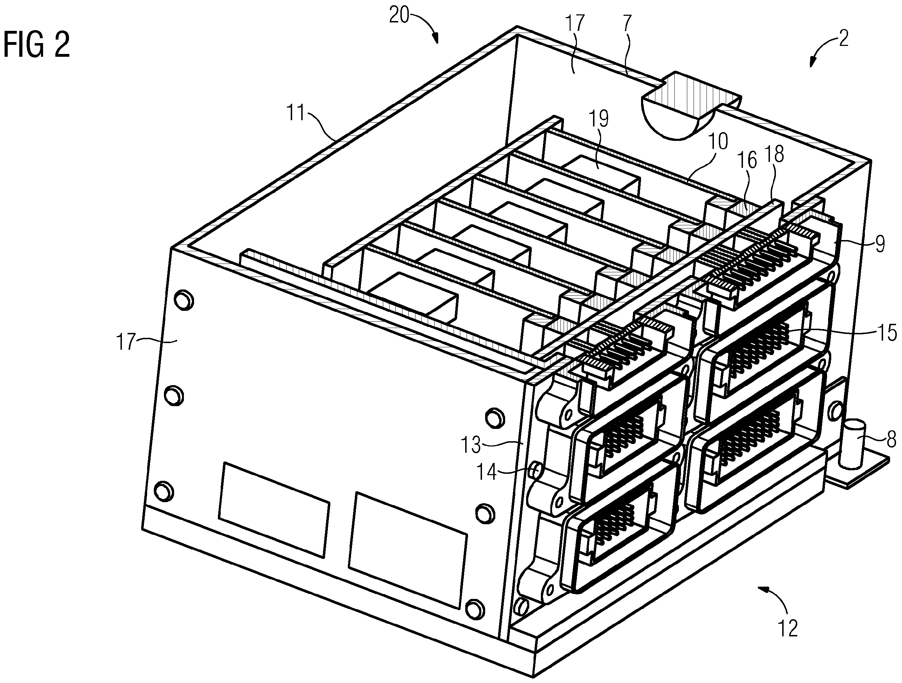

Im Folgenden wird die Brandschutzeinrichtung 2 mit Bezug auf Figur 2 beschrieben. Zur besseren Darstellung ist die Brandschutzeinrichtung 2 in Figur 2 mit teilweise geöffnetem Gehäuse 7(Querschnitt) gezeigt.

Das Gehäuse 7 der Brandschutzeinrichtung 2 ist im Wesentlichen kastenförmig ausgebildet und aus Blech oder anderem Material hergestellt. Das Gehäuse 7 besteht aus einem Kasten 11 mit frontseitiger Öffnung 12 und einer Abdeckung 13, die die Öffnung 12 im geschlossenen Zustand in Figur 2 verschließt. Die Abdeckung ist im geschlossenen Zustand des Gehäuses 7 in Figur 2 durch Schrauben 14 mit dem Kasten 11 verbunden.

Die Steckverbinder 9 sind bei der Ausführungsform der Figuren 1 und 2 in der Wandung, insbesondere der Abdeckung 13, des Gehäuses 7 eingelassen. Die Steckverbinder 9 sind also als Einbaustecker ausgebildet, die ortsfest in das Gehäuse 7 eingebaut sind. Die Steckverbinder 9 weisen jeweils eine Vielzahl von vom Gehäuse 7 nach außen stehenden Kontaktstiften 15 auf, die im Innern des Gehäuses 7 mit dem internen Netz 20 der Brandschutzeinrichtung 2 verbunden sind, wie im Folgenden noch näher erläutert wird. Die Kontaktstifte 15 sind insbesondere mit Steckerelementen 16 auf der Innenseite der Abdeckung 13 verbunden, die eine Steckverbindung zu den Platinen 10 herstellen. Bei der Ausführungsform der Figuren 1 und 2 umfasst die Brandschutzeinrichtung 2 sechs Steckverbinder 9, die in drei Reihen übereinander und zwei Spalten nebeneinander angeordnet sind.

Die Platinen 10 sind parallel zueinander und im Wesentlichen rechtwinklig zur Abdeckung 13, parallel zu den Seitenwänden 17 des Gehäuses 7 eingebaut. Hinter den Steckverbindern 9 sind die Platinen 10 jeweils in Platinensteckaufnahmen (nicht dargestellt) einer Querplatine 18 (Backplane) eingesteckt. Die Platinen 10 sind jeweils als gedruckte Platinen ausgebildet, auf die Bauteile und Leiterbahnen aufgedruckt sind. Gedruckte Platinen werden auch als Printed Circuit Board (PCB) bezeichnet. Die Platinen weisen als Bauteile Relais 19, DC-Wandler (nicht dargestellt) und andere elektrische Bauteile auf. Bei der beispielhaften Ausführungsform der Figuren 1 und 2 sind jeweils eine oder mehrere Funktionen der Brandschutzeinrichtung 2 auf einer der Platinen 10 ausgebildet. Trotzdem sind die Platinen 10 von ihren Abmessungen alle gleich und kommen so mit dem vorgesehenen Bauraum an den verschiedenen Steckplätzen der Querplatine 18 aus. Die steckbaren Platinen 19 sind durch die Steckkontakte zu der Querplatine 18 leicht austauschbar.

Die oben genannten Funktionen der Brandschutzeinrichtung 2, die auf den Platinen 10 durch entsprechende Bauteile und Verbindungen ausgebildet sind, umfassen hier eine Brandmeldeanlage, eine Notfahreinrichtung des Fahrzeugs 1 und ein Personeninformationssystem, insbesondere für Sprachanweisungen an die Fahrgäste. Über die Steckverbinder 9 sind die Bauteile auf den Platinen 10 vom Gehäuse 7 aus betrachtet nach außen verbindbar und über die Querplatine 18 intern verbunden. Die interne Verbindung, also die Verbindung im Innern des Gehäuses 7 ist nötig, weil die unterschiedlichen Funktionen, die in der Brandschutzeinrichtung 2 ausgebildet sind, miteinander kommunizieren müssen. Durch die interne Verbindung kann der Verkabelungsaufwand außerhalb des Gehäuses 7 reduziert werden.

Das Fahrzeug 1 weist für jeden Steckverbinder 9 der Brandschutzeinrichtung 2 einen Gegensteckverbinder 23 auf, über den die Bauteile im Innern der Brandschutzeinrichtung 2 mit Bauteilen eines externen Netzes 21 des Fahrzeugs 1 außerhalb des Gehäuses 7 kommunizieren. Solche Bauteile des externen Netzes 21 im Fahrzeug 1 können beispielsweise Lautsprecher, Sensoren, Energieversorgung, Leuchtmittel, Signalleitungen und ähnliches sein.

In der Brandschutzeinrichtung 2 sind Bauteile angeordnet, die für den Fall eines Brandes im Fahrzeug 1 besonders gegen die Einflüsse eines Feuers geschützt sind. Diese Bauteile bilden Funktionen des Fahrzeugs 1 aus, die auch oder gerade bei einem Brand zumindest für eine vorgegebene Zeit weiterhin funktionieren müssen. Wie oben bereits erwähnt, können diese Funktionen beispielsweise eine Weiterfahrt des Fahrzeugs, Ausgabe von Fahrgastinformationen und eine Brandmeldeanlage sein. Die Funktionen müssen eine vorgegebene Zeit bei einem Brand weiterfunktionieren. Hierfür muss die Brandschutzeinrichtung 2 insbesondere durch das Gehäuse 7 einen gewissen Brandwiderstand leisten. Die Widerstandsfähigkeit gegen Brand hängt von der sogenannten Brandlast des Einbauorts ab.

Unter der Brandlast eines bestimmten Bereichs des Fahrzeugs versteht man die Energie, die bei einem Brand in diesem Bereich frei wird und damit für Schutzmaßnahmen gegen einen solchen Brand zu berücksichtigen ist.

Die Brandlast des Fahrgastbereichs 4 des Fahrzeugs 1 ist größer als die Brandlast des Unterflurbereichs 6. Dies ist dadurch zu erklären, dass Fahrgäste im Fahrgastbereich viele Gegenstände mit sich führen, die eine hohe Brandlast aufweisen, wie beispielsweise Gepäckstücke, Zeitungen etc. Da im Unterflurbereich 6 weniger brennbare Gegenstände angeordnet sind, ist die Brandlast des Unterflurbereichs 6 geringer. Da die Brandschutzeinrichtung 2 im Fahrzeug 1 im Unterflurbereich 6 angeordnet ist, muss das Gehäuse 7 weniger Brandschutz und Flammbarrieren bieten, als wenn die Brandschutzeinrichtung 2 im Fahrgastbereich 4 angeordnet wäre. Die Anordnung der Brandschutzeinrichtung 2 im Unterflurbereich 6 ist also vorteilhaft. Da viele andere elektrische Einrichtungen des Fahrzeugs 1 ebenfalls im Unterflurbereich 6 angeordnet sind, ist auch die Verkabelung von und zu der Brandschutzeinrichtung 2 durch die Anordnungen im Unterflurbereich 6 einfacher. Da sämtliche Schaltelemente des Fahrzeugs 1, die vor einem Brand besonders zu schützen sind, in dem einen Gehäuse der Brandschutzeinrichtung 2 angeordnet sind, ist nur ein Gehäuse 7 nötig.

Durch die Steckverbinder 9 und die Befestigungsmittel 8 kann die Brandschutzeinrichtung 2 besonders schnell im Fahrzeug 1 montiert und angeschlossen werden. Durch die modulartige Ausgestaltung der Brandschutzeinrichtung 2 mit den Steckverbindern 9 und dem geschlossenen Gehäuse 7 kann die Brandschutzeinrichtung 2 separat vom Fahrzeug 1 vormontiert und getestet werden. Weiterhin lässt sich die Brandschutzeinrichtung 2 bei einem Fehler während des Betriebs besonders schnell und einfach im Fahrzeug 1 ausbauen und gegen eine neue Brandschutzeinrichtung 2 austauschen. Die ausgebaute fehlerhafte Brandschutzeinrichtung 2 kann anschließend separat vom Fahrzeug 1 repariert und getestet werden, ohne dass das Fahrzeug 1 ausfällt.

Je nach Ausführung (Anzahl und Konfiguration der Platinen 10) kann die Brandschutzeinrichtung 2 eine maximale Anzahl von möglichen Funktionen ermöglichen oder ist nur für eine bestimmte wagenspezifische Funktion ausgelegt. Im ersten Fall ist die Brandschutzeinrichtung 2 für jedes Fahrzeug 1 immer identisch und die benötigten Funktionen sind per Gegensteckverbinder 23 und per externem elektrischem Netz 2 nur wagennotwendige Funktionen, was aber zu unterschiedlichen Ausführungen der Brandschutzeinrichtung 2 führt.

Durch die Verwendung von Relais anstatt von früher üblichen Schützen ist die Wärmeentwicklung im Gehäuse 7 der Brandschutzeinrichtung 2 relativ gering, so dass die Gefahr eines Feuers im Innern der Brandschutzeinrichtung 2 gering ist. Da Relais im Vergleich zu Schützen klein und leicht sind, ist das Volumen und das Gewicht der Brandschutzeinrichtung 2 relativ gering.

Die im Innern des Gehäuses 7 angeordneten Platinen 10, Steckerelementen 16 und Querplatine 18 bild das interne elektrische Netz 20 aus. Das elektrische Netz im Fahrzeug 1, das außerhalb vom Gehäuse 7 der Brandschutzeinrichtung 2 verläuft, stellt das externe elektrische Netz 21 dar. Die Steckverbinder 9 der Brandschutzeinrichtung 2 sind mit dem internen Netz 20 verbunden. Das externe Netz 21 des Fahrzeugs 1 ist wiederum mit den Gegensteckverbindern 23 verbunden, die mit den Steckverbindern 9 zu einer Steckverbindung verbunden sind.

Das Fahrzeug 1 weist ein brandgeschütztes elektrisches Netz 22 auf, zu dem die Brandschutzeinrichtung 2 und alle übrigen elektrischen Bauteile des Fahrzeugs 1, die vor einem Brand geschützt sind, zählen. Diese Bauteile sind beispielsweise feuergeschützte Leitungen, Lautsprecher, Notbeleuchtung etc.

## Patentansprüche

1. Fahrzeug (1), insbesondere zur Personen- und/oder Gutbeförderung,
mit wenigstens einem brandgeschützten elektrischen Netz (22, 20),
mit wenigstens einem ersten Fahrzeugbereich (4), der eine erste Brandlast aufweist und zur Personen- und/oder Gutbeförderung ausgestaltet ist, und
mit wenigstens einem zweiten Fahrzeugbereich(6), der eine zweite zur ersten Brandlast kleinere Brandlast aufweist und nicht zur Personen- und/oder Gutbeförderung ausgestaltet ist,
**dadurch gekennzeichnet, dass**
wenigstens ein Teil des brandgeschützten Netzes (22, 20) in dem zweiten Fahrzeugbereich (6) angeordnet ist und das Fahrzeug (1) wenigstens ein Brandschutz gebendes Gehäuse (7) im zweiten Fahrzeugbereich (6) umfasst, in dem wenigstens ein Teil des brandgeschützten Netzes (20) angeordnet ist.

2. Fahrzeug (1) nach Anspruch 1,
**dadurch gekennzeichnet, dass**
der zweite Fahrzeugbereich (6) unterhalb des ersten Fahrzeugbereichs (4) angeordnet ist.

3. Fahrzeug (1) nach einem der oben genannten Ansprüche,
**dadurch gekennzeichnet, dass**
das Fahrzeug einen Fahrzeugkasten aufweist, der im zweiten Fahrzeugbereich (6) wenigstens einen brandgeschützten Abschnitt ausbildet, und dass zumindest ein Teil des brandgeschützten Netzes(22, 20) in dem brandgeschützten Abschnitt angeordnet ist.

4. Fahrzeug (1) nach Anspruch 3,
**dadurch gekennzeichnet, dass**
das brandgeschützten Netz wenigstens einen Steckverbinder (9) umfasst, durch den das brandgeschützte Netz (22, 20) im Innern des Gehäuses mit einem vom Gehäuse (7) externen Netz (21) verbindbar ist.

5. Fahrzeug (1) nach Anspruch 4,
**dadurch gekennzeichnet, dass**
das brandgeschützte Netz (22, 20) mehrere Teilnetze mit unterschiedlichen im Brandfall erforderlichen Funktionalitäten umfasst, wobei alle Teilnetze in einem gemeinsamen Gehäuse (7) angeordnet sind.

6. Fahrzeug (1) nach einem der oben genannten Ansprüche,
**dadurch gekennzeichnet, dass**
das brandgeschützte Netz (20, 22) wenigstens eine gedruckte Platine (10) umfasst.

7. Fahrzeug (1) nach Anspruch 6,
**dadurch gekennzeichnet, dass**
das brandgeschützte Netz (22, 20) wenigstens ein Schaltelement, insbesondere ein Relais (19), umfasst, das auf der Platine (10) angeordnet ist.

## Claims

1. Vehicle (1), in particular for conveying people and/or freight,
having at least one fireproof electrical network (22, 20),
at least one first vehicle region (4) which has a first fire load and is designed for the purpose of conveying people and/or freight, and
at least one second vehicle region (6) which has a second fire load which is smaller than the first fire load and is not designed for the purpose of conveying people and/or freight,
**characterised in that**
at least part of the fireproof network (22, 20) is arranged in the second vehicle region (6) and the vehicle (1) comprises at least one fire-protective housing (7) in the second vehicle region (6), in which at least part of the fireproof network (20) is arranged.

2. Vehicle (1) according to claim 1,
**characterised in that**
the second vehicle region (6) is arranged below the first vehicle region (4).

3. Vehicle (1) according to one of the preceding claims,
**characterised in that**
the vehicle has a vehicle body which forms at least one fireproof section in the second vehicle region (6), and that at least part of the fireproof network (22, 20) is arranged in the fireproof section.

4. Vehicle (1) according to claim 3,
**characterised in that**
the fireproof network comprises at least one plug-type connector (9), by means of which the fireproof network (22, 20) inside the housing can be connected to a network (21) that is external to the housing (7).

5. Vehicle (1) according to claim 4,
**characterised in that**
the fireproof network (22, 20) comprises a plurality of subnetworks having different functionalities required in the event of fire, wherein all subnetworks are arranged in a shared housing (7).

6. Vehicle (1) according to one of the preceding claims,
**characterised in that**
the fireproof network (20, 22) comprises at least one printed circuit board (10).

7. Vehicle (1) according to claim 6,
**characterised in that**
the fireproof network (22, 20) comprises at least one switching element, in particular a relay (19), which is arranged on the circuit board (10).

## Revendications

1. Véhicule (1), notamment de transport de personnes et/ou de marchandises,
comprenant un réseau (22, 20) électrique protégé de l'incendie,
comprenant au moins une première partie (4) du véhicule, qui a une première charge calorifique et qui est conformée pour le transport de personnes et/ou de marchandises, et comprenant au moins une deuxième partie (6) de véhicule, qui a une deuxième charge calorifique plus petite que la première charge calorifique et qui n'est pas conformée pour le transport de personnes et/ou de marchandises,
**caractérisé en ce que**
au moins une partie du réseau (22, 20) protégé de l'incendie est disposée dans la deuxième partie (6) du véhicule et le véhicule (1) comprend, dans la deuxième partie (6) du véhicule, au moins une enveloppe (7), qui donne une protection vis-à-vis de l'incendie et dans laquelle est disposée au moins une partie du réseau (20) protégé de l'incendie.

2. Véhicule (1) suivant la revendication 1,
**caractérisé en ce que**
la deuxième partie (6) du véhicule est disposée en dessous de la première partie (4) du véhicule.

3. Véhicule (1) suivant l'une des revendications précédentes,
**caractérisé en ce que**
le véhicule a une caisse, qui constitue au moins un segment protégé de l'incendie dans la deuxième partie (6) du véhicule et **en ce qu'**au moins une partie du réseau (22, 20) protégé de l'incendie est disposée dans le segment protégé de l'incendie.

4. Véhicule (1) suivant la revendication 3,
**caractérisé en ce que** le réseau protégé de l'incendie comprend au moins un connecteur (9) à enfichage, par lequel le réseau (22, 20) protégé de l'incendie peut être relié à l'intérieur de l'enveloppe à un réseau (21) extérieur à l'enveloppe 7.

5. Véhicule (1) suivant la revendication 4,
**caractérisé en ce que**
le réseau (22, 20) protégé de l'incendie comprend plusieurs sous-réseau ayant des fonctionnalités différentes nécessaires en cas d'incendie, tous les sous-réseaux étant disposés dans une enveloppe (7) commune.

6. Véhicule (1) suivant l(une des revendications précédentes,
**caractérisé en ce que**
le réseau (20, 22 ) protégé de l'incendie comprend au moins une plaquette (10) à circuit imprimé.

7. Véhicule (1) suivant la revendication 6,
**caractérisé en ce que** le réseau (22, 20) protégé de l'incendie comprend au moins un élément de coupure, notamment un relais (9), qui est monté sur la plaquette (10) à circuit imprimé.
